# EUROPEAN PATENT APPLICATION

(11) **EP 2 533 269 A2**
(43) Date of publication of application: **12.12.2012**
(21) Application number: 12170969.5
(22) Date of filing: 06.06.2012
(51) Int. Cl.: H01J 37/32

(54) **High frequency power distribution device and substrate processing apparatus using same**

(30) Priority: 10.06.2011 JP 2011130508
(71) Applicant: TOKYO ELECTRON LIMITED, Minato-ku Tokyo 107-6325 (JP)
(72) Inventor: Hanawa, Kenichi, Yamanashi, 407-8511 (JP); Tomita, Takahiro, Yamanashi, 407-8511 (JP)
(74) Representative: HOFFMANN EITLE

(57) **Abstract**

A high frequency power distribution device includes: a distribution member for uniformly dividing a high frequency power into divided high frequency powers; coaxial transmission lines through which the divided high frequency powers are introduced to the parallel plate electrodes; and an impedance control mechanism which controls an input impedance to decrease a current value. The distribution member includes: a high frequency power input unit for inputting the high frequency power to an input point; and a plurality of high frequency power output units spaced from each other at a regular interval, and each of the coaxial transmission lines are connected to one of the high frequency power output units, and the impedance control mechanism is provided at the high frequency power input unit.

## Description

### Field of the Invention

The present invention relates to a high frequency power distribution device that can be used in plasma processing on a plurality of substrates in a single chamber, and a substrate processing apparatus using the same.

### Background of the Invention

Conventionally, there is known an apparatus for performing plasma processing on a plurality of substrates in a single chamber. In this apparatus, multiple pairs of anode and cathode electrodes are provided in a chamber, and a power introductory line passes through a matching box from a power supply provided outside the chamber and branches into power inlet lines corresponding to the number of the cathode electrodes, the power inlet lines extending in a symmetric pattern. By connecting the power inlet lines to the cathode electrodes as such, a high frequency power is supplied (see, e.g., Japanese Patent Application Publication No. 2006-196681).

In Japanese Patent Application Publication No. 2006-196681, the high frequency power is distributed to the cathode electrodes by using multi-step division. Between the matching unit (the matching box) and the cathode electrodes, specifically, the power introductory line is divided into a plurality of power inlet lines corresponding to the number of the cathode electrodes in a manner that the power introductory line is divided into two power inlet lines, and then each of the divided power inlet lines is further divided into two lines, and so on. Thus, the power can be uniformly supplied to a plurality of discharge spaces in the chamber without requiring a particular control mechanism.

However, in the technique described above, since the matching unit has a low output impedance, a change in the output impedance may occur due to a minor error in installation, which leads to a great change in current. Further, in the case of distributing the high frequency power by using multi-step division, the coaxial cable cannot be used as the power supply line and, hence, a difference may occur between the high frequency powers inputted into the respective electrodes.

Accordingly, in the above-mentioned technique, actual processing performed in a plurality of discharge spaces in the chamber is not uniform, and this results in characteristic variations of the products. Moreover, when a large current flows through a low impedance circuit, power loss is caused by heat generation. In the case of performing the multi-step division by multiples of two, the number of divided power inlet lines is limited to 2ⁿ (n being a positive integer) and it is impossible to perform division by an arbitrary number.

### Summary of the Invention

In view of the above, the present invention provides a high frequency power distribution device capable of uniformly dividing a high frequency power by a desired number and reducing power loss and processing variation in a plurality of discharge spaces where substrates are processed, and a substrate processing apparatus using the same.

In accordance with a first aspect of the present invention, there is provided a high frequency power distribution device for uniformly distributing a high frequency power from a high frequency power supply to a plurality of parallel plate electrodes in a substrate processing apparatus for processing a plurality of substrates in batches by generating a plasma by the high frequency power supplied to the parallel plate electrodes, the high frequency power distribution device including: a distribution member for uniformly dividing a high frequency power inputted thereto into a plurality of divided high frequency powers; coaxial transmission lines, each of which has a central power supply line and a ground line disposed around the central power supply line, to transmit the divided high frequency powers to the parallel plate electrodes; and an impedance control mechanism which controls an input impedance to decrease a current value.

The distribution member includes: a main body made of a plate-shaped conductor; a high frequency power input unit for inputting the high frequency power to an input point disposed on one surface of the main body; and a plurality of high frequency power output units spaced from each other at a regular interval around a circle centering a point that is formed at the other surface of the main body so as to correspond to the input point, wherein each of the coaxial transmission lines is connected to one of the high frequency power output units, and the impedance control mechanism is provided at the high frequency power input unit.

In accordance with a second aspect of the present invention, there is provided a substrate processing apparatus for performing plasma processing on a plurality of substrates in batches, the apparatus including: a plurality of parallel plate electrodes for generating a plasma for each of the substrates, the plate electrodes including high frequency power application electrodes; a high frequency power supply for supplying a high frequency power to the high frequency power application electrodes; an impedance matching unit provided between the high frequency power supply and the high frequency power application electrodes; and a high frequency power distribution device, provided between the impedance matching unit and the high frequency power application electrodes, for uniformly distributing the high frequency power supplied from the high frequency power supply via the matching unit to the high frequency power application electrodes.

Further, the high frequency power distribution device includes: a distribution member for uniformly dividing the high frequency power inputted thereto into a plurality of divided high frequency powers; coaxial transmission lines each of which has a central power supply line and a ground line disposed around the central power supply line, to transmit the divided high frequency powers to the high frequency power application electrodes; and an impedance control mechanism which controls an input impedance to decrease a current value.

Furthermore, the distribution member includes: a main body made of a plate-shaped conductor; a high frequency power input unit for inputting the high frequency power to an input point disposed on one surface of the main body; and a plurality of high frequency power output units spaced from each other at a regular interval around a circle centering a point that is formed on the other surface of the main body so as to correspond to the input point, and each of the coaxial transmission lines is connected to one of the high frequency power output units, and the impedance control mechanism is provided at the high frequency power input unit.

With the present invention, the high frequency power can be uniformly divided by the distribution member. Further, the number of division can be changed without being limited to 2ⁿ (n being positive integers). Moreover, all the high frequency output units are provided at the main body. Therefore, the coaxial transmission line can be used as the high frequency power output line of the high frequency output units, and the variation in the high frequency power inputted to the parallel plate electrodes can be reduced by equalizing the impedances of the power supply lines to the parallel plate electrodes.

Further, with the impedance control mechanism provided at the high frequency power input unit of the distribution member, the current value can be decreased by increasing the impedance of the high frequency power input unit and the variation in the current value caused by an installation error can be reduced. Hence, the variation in the plasma processing in a plurality of processing spaces corresponding to the parallel plate electrodes can be decreased, and the variation in the characteristics of the products can be reduced. In addition, since the current level is decreased by increasing the impedance, power loss caused by heat generation can be reduced.

### Brief Description of the Drawings

The objects and features of the present invention will become apparent from the following description of embodiments, given in conjunction with the accompanying drawings, in which:
Fig. 1 is a perspective view showing a substrate processing apparatus in accordance with an embodiment of the present invention;
Fig. 2 is a cross sectional view depicting the substrate processing apparatus in accordance with the embodiment of the present invention;
Figs. 3A to 3C illustrate a high frequency power distribution device;
Fig. 4 represents another example of the high frequency power distribution device;
Fig. 5 shows a configuration of an electrode connection box;
Fig. 6 illustrates an example in which power is supplied to four portions;
Fig. 7 is a schematic diagram showing a substrate processing apparatus in accordance with another embodiment of the present invention;
Fig. 8 is a schematic diagram depicting a substrate processing apparatus in accordance with still another embodiment of the present invention; and
Fig. 9 is a schematic diagram representing a substrate processing apparatus in accordance with still another embodiment of the present invention.

### Detailed Description of the Embodiments

Hereinafter, embodiments of the present invention will be described with reference to the accompanying drawings which form a part hereof.

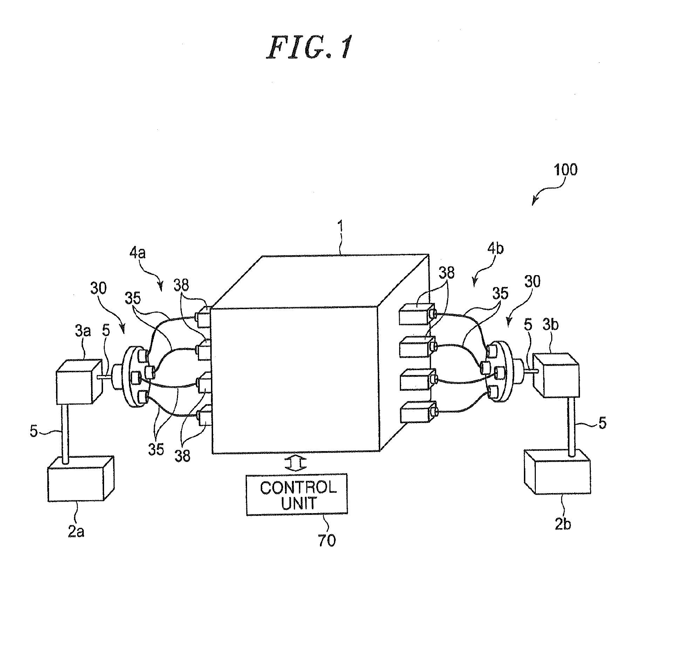

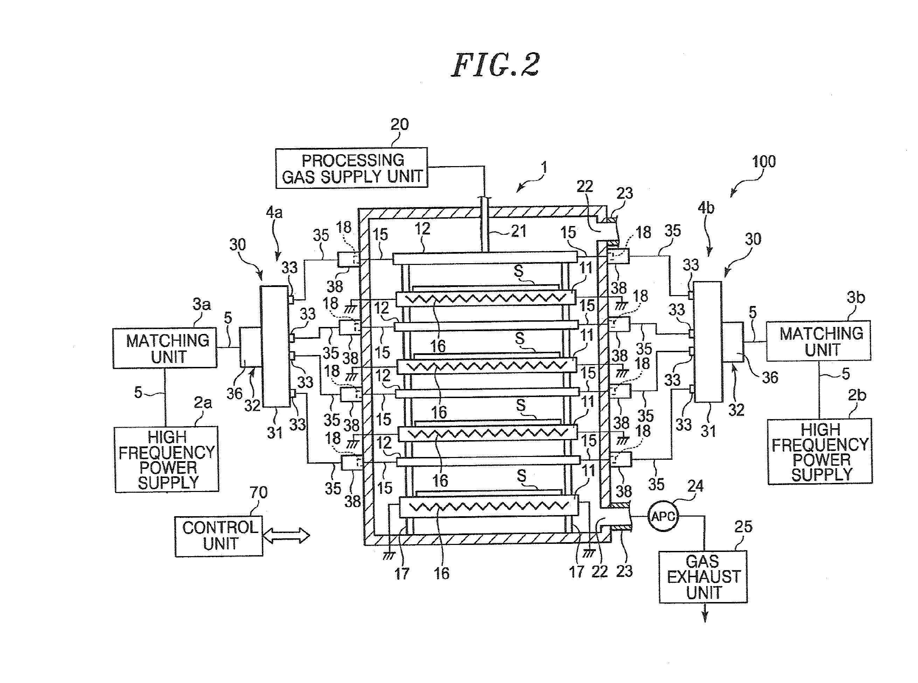

Fig. 1 is a perspective view showing a substrate processing apparatus in accordance with an embodiment of the present invention. Fig. 2 depicts a cross sectional view of the substrate processing apparatus.

A substrate processing apparatus 100 is configured as a parallel plate type plasma processing apparatus for performing plasma processing on a plurality of substrates. The substrate processing apparatus 100 includes a chamber 1 for performing plasma processing on a plurality of (e.g., four in Fig. 2) substrates S accommodated therein, and two high frequency power supply units 2a and 2b for supplying high frequency powers for plasma generation into the chamber 1. Further, the substrate processing apparatus 100 includes matching units 3a and 3b, connected to the high frequency power supply units 2a and 2b, respectively, for matching impedances between the power supplies and the plasma, and high frequency power distribution devices 4a and 4b provided between the matching units 3a and 3b and the chamber 1.

Besides, coaxial cables 5, each having a central power supply line and a ground line that is coaxially disposed around the central power supply line, are provided for connection between the high frequency power supply units 2a and 2b and the matching units 3a and 3b and between the matching units 3a and 3b and the high frequency power distribution devices 4a and 4b. The connection therebetween may be achieved by coaxial connectors instead of the coaxial cables 5.

A transfer port (not shown) capable of transferring a plurality of substrates in batches is formed at a sidewall of the chamber 1. The transfer port can be opened and closed by a gate valve (not shown).

A plurality of (e.g., four) lower electrodes (anode electrodes), each serving as a mounting table for mounting a substrate S thereon, is provided in the chamber 1 at vertical multiple stages. Further, a plurality of (e.g., four) upper electrodes (cathode electrodes) is provided so as to face the lower electrodes 11. In other words, there are provided four parallel plate electrodes having pairs of the lower electrodes 11 and the upper electrodes 12.

Connected to both end portions of each of the upper electrodes 12 are high frequency power introduction rods 15 for introducing high frequency powers distributed by the high frequency power distribution devices 4a and 4b. Further, introduction terminals 18 for introducing the high frequency powers to the upper electrodes 12 via the high frequency power introduction rods 15 are provided outside the chamber 1. Meanwhile, both end portions of each of the lower electrodes 11 are grounded.

Heaters 16 are embedded in the lower electrodes 11. The heaters 16 generate heat by power supplied from a power supply (not shown), thereby heating substrates S mounted on the lower electrodes 11 to a predetermined temperature.

A gas supply line 21 is connected to a top surface of each of the upper electrodes 12 (only the connection between the gas supply line 21 and the uppermost upper electrode 12 is shown), thereby supplying a processing gas from a processing gas supply unit 20 thereto. A plurality of gas injection holes (not shown) are formed at a bottom surface of each of the upper electrodes 12, so that the processing gas is supplied in a shower shape to the substrate S mounted on the lower electrodes 11. In other words, the upper electrodes 12 serve as shower heads for supplying the processing gas.

The lower electrodes 11 and the upper electrodes 12 are supported by supporting members 17 in the chamber 1. Moreover, the lower electrodes 11 and the upper electrodes 12 can be vertically moved by an elevation mechanism (not shown), so that a distance between the lower electrodes 11 and the upper electrodes 12 can be adjusted.

Gas exhaust ports 22 for exhausting the interior of the chamber 1 are provided at an upper and a lower portion of the chamber 1. Gas exhaust lines 23 are connected to the gas exhaust ports 22. An automatic pressure control valve (APC) 24 and a gas exhaust unit 25 are provided in each of the gas exhaust lines 23. Therefore, the gas exhaust units 25 control the interior of the chamber 1 to a predetermined vacuum atmosphere while controlling a pressure in the chamber 1 by using the automatic pressure control valves (APC) 24.

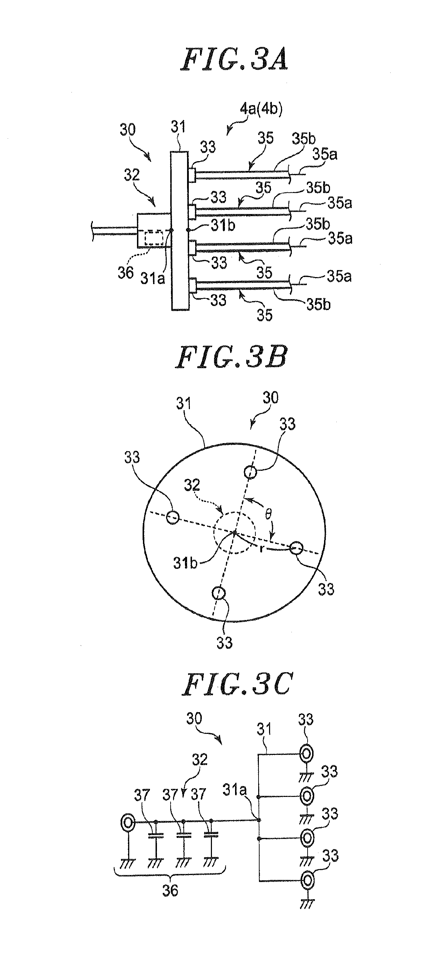

As shown in Fig. 3, the high frequency power distribution devices 4a (4b) includes a distribution member 30 for distributing the high frequency power supplied from the high frequency power supply unit 2a (2b) into two or more parts, coaxial cables (coaxial transmission lines) 35 for transmitting the high frequency powers distributed by the distribution member 30, and an impedance control mechanism 36.

The distribution member 30 includes: a main body 31 made of a circular plate-shaped conductor; a high frequency power input unit 32 for inputting a high frequency power to an input point 31a formed on one surface of the main body 31; and a plurality of high frequency power output units 33 spaced apart from each other at a regular interval around a circle centering a point 31b that is formed on the other surface of the main body 31 so as correspond to the input point 31a. In other words, each of the high frequency power output units 33 is positioned at a distance of r from the point 31b corresponding to the input point 31a, and an angle θ formed by a straight line extending from the point 31b to one of the high frequency power output units 33 and a straight line extending from the point 31b to another high frequency power output unit 33 adjacent thereto is about 90°.

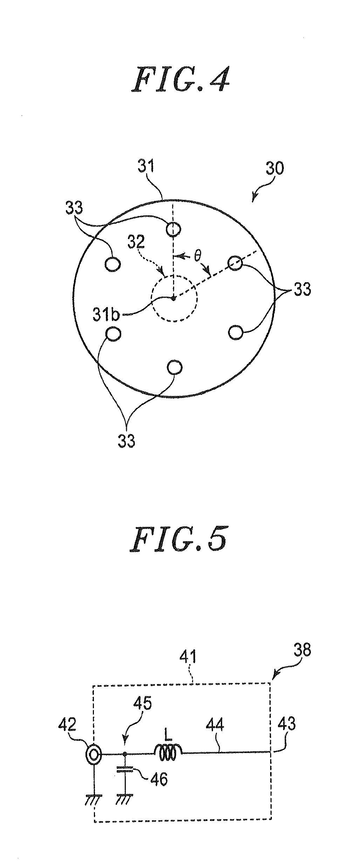

The input point 31a is disposed at the central portion of the main body 31 so that the power is distributed more symmetrically. The number of the high frequency power output units 33 can vary as long as they are spaced apart from each other at a regular interval about the circle centering the point 31b corresponding to the input point 31a. Fig. 4 shows an example in which six high frequency power output units 33 are provided. In that case, the angle θ is about 60°.

Further, the main body 31 does not necessarily have a circular plate shape, and may have another shape such as a regular quadrilateral plate shape or the like. Since, however, the impedance needs to be equalized in each of the distribution paths, it is preferable to employ an N-fold rotationally symmetric shape corresponding to the division number N of the high frequency power. Due to the uniform arrangement of the high frequency power output units 33, the high frequency power can be uniformly distributed through the high frequency power output units 33.

The coaxial cables (the coaxial transmission lines) 35 transmit the high frequency powers outputted from the high frequency power output units 33. Each of the coaxial cables has a power supply line 35a connected to a high frequency power output unit 33 and a ground line 35b coaxially provided around the power supply line 35a. As for the coaxial cables 55, it is possible to use one having a characteristic impedance of about 50 Ω, and connectors provided at both end portions thereof can be selected in accordance with a frequency and a rated power of the high frequency power.

The impedance control mechanism 36 is provided at the high frequency power input unit 32 to decrease a current value by increasing an impedance of the high frequency power input unit 32. As shown in Fig. 3C, the impedance control mechanism 36 has a configuration in which a plurality of (three in Fig. 3C) capacitors 37 are connected in parallel to the high frequency power input unit 32. Hence, the impedance is increased and thus the current value can be reduced. As for the capacitors 37, a fixed capacitor is preferably used. The element constant (i.e., capacitance) of the capacitors varies in accordance with the frequency of the high frequency power or the like.

Electrode connection boxes 38 are provided at the end portions of the coaxial cables 35 in order to connect the coaxial cables 35 to the introduction terminals 18. As shown in Fig. 5, the electrode connection box 38 includes: a housing 41; an input unit 42 of the housing 41 to which the coaxial cable 35 is connected; an output unit 42 of the housing 41 from which a high frequency power is outputted; and a high frequency power line 44 for connecting the input unit 42 and the output unit 43.

An impedance adjustment mechanism 45 for controlling an impedance of the high frequency power line 44 is connected to the high frequency power line 44. The impedance adjustment mechanism 45 has, e.g., a capacitor 46 connected in parallel to the high frequency power line 44. Accordingly, the impedance of the high frequency power line 44 is increased and thus the current value can be decreased. A notation L indicates a parasitic inductance of the high frequency power line 44.

The output unit 43 of the electrode connection box 38 is designed in accordance with the high frequency power introduction rod 15 extended from the upper electrode 12. The housing 41 is directly attached to the chamber 1 as a ground of the high frequency power.

Parts of the substrate processing apparatus 100 are controlled by a control unit (computer) 70. The control unit 70 includes a controller having a micro processor, and a user interface having a keyboard for allowing an operator to input commands for managing the substrate processing apparatus 100, a display for visually displaying an operation status of the substrate processing apparatus 100 and the like. The control unit 70 further includes a storage unit for storing therein control programs for implementing various processes performed in the substrate processing apparatus 100 under the control of the controller or processing recipes for performing a predetermined process in the substrate processing apparatus 100 in accordance with processing conditions.

The processing recipes and the like are stored in a storage medium and read out from the storage medium in the storage unit so as to be executed. The storage medium may be a hard disk or a semiconductor memory, or may also be a portable medium such as a CD-ROM, a DVD, a flash memory or the like. If necessary, the recipes and the like are read out from the storage unit according to an instruction from the user interface and executed in the controller. Accordingly, a desired process is performed in the substrate processing apparatus 100 under the control of the controller.

In the substrate processing apparatus 100 configured as described above, first, a gate valve opens, and a plurality of substrates S is loaded into the chamber 1 by a transfer device (not shown) through a transfer port to be mounted on the lower electrodes 11. Next, the transfer device is retreated from the chamber 1, and the gate valve is closed. Then, the chamber 1 is exhausted to a predetermined vacuum atmosphere by the gas exhaust unit 25. At this time, the substrates S on the lower electrodes 11 are heated to a predetermined temperature by the heaters 16.

Thereafter, a processing gas is supplied from the processing gas supply unit 20 to the upper electrodes 12 through the gas supply line 21. Then, the processing gas is discharged in a shower shape from the gas injection holes formed at the bottom surfaces of the upper electrodes 12. At the same time, high frequency powers are supplied from the high frequency power supply units 2a and 2b to both end portions of each of the upper electrodes 12 via the matching units 3a and 3b and the high frequency power distribution devices 4a and 4b.

Accordingly, a high frequency electric field is generated between the upper electrodes 12 and the lower electrodes 11 facing each other. As a consequence, a plasma of the processing gas is generated, and predetermined plasma processing, e.g., plasma CVD, is performed on the substrates S heated by the heaters by the plasma thus generated.

At this point, the high frequency power distribution devices 4a and 4b can uniformly distribute the high frequency power by using the distribution member 30 that includes the main body 31 made of a circular plate-shaped conductor, the high frequency power input unit 32 for inputting a high frequency power into the input point 31a formed on one surface of the main body 31, and the high frequency power output units 33 spaced apart from each other at a regular interval about the circle centering the point 31b that is formed on the other surface of the main body 31 so as to correspond to the input point 31a. Since the high frequency power output units are uniformly formed at regular interval on the circular plate, the division number of the high frequency power can be arbitrarily changed without being limited to 2ⁿ (n being a positive integer).

All the high frequency power output units 33 are provided at the main body 31. Accordingly, the coaxial cables 35 can be used as lines for outputting the high frequency powers from the high frequency power output units 33. Thus, the impedance of the power supply lines to the upper electrodes 12 can be equalized, and the variation in the high frequency powers inputted to the upper electrodes 12 can be decreased.

Since the impedance control mechanism 36 is provided at the high frequency power input unit 32 of the distribution member 30, the current value can be reduced by increasing the impedance of the high frequency power input unit 32 and the variation in the current value due to the installation error can be reduced. Accordingly, the variation in the plasma processing in the processing spaces formed between the upper electrode 12 and the lower electrode 11 can be decreased, and the variation in the characteristics of the products can be reduced.

Besides, the current value can be reduced by increasing the impedance and, thus, power loss caused by heat generation can be reduced. In the case of using the coaxial cables, although the installation or the assembly of the apparatus becomes convenient, the current value is restricted. With the present embodiment as described above, the coaxial cables 35 can be used by controlling the impedance at the high frequency power input unit 32.

Furthermore, with the impedance adjustment mechanisms 45 provided in the electrode connection boxes 38, even if there is an individual variation caused by an intrinsic impedance of each of the upper electrodes 12, the individual variation can be corrected by controlling the current flowing through the upper electrodes 12, thereby further decreasing variations in plasma processing. Besides, the current flowing through the coaxial cables 35 can be reduced by increasing the impedance by the impedance adjustment mechanisms 45.

Moreover, it is possible to change circuit constant by adjusting a length of the coaxial cable 35 and/or a capacitance of the capacitors of the distribution member 30 and/or the electrode connection box 38. This makes it possible to use various frequencies in the embodiments of the invention.

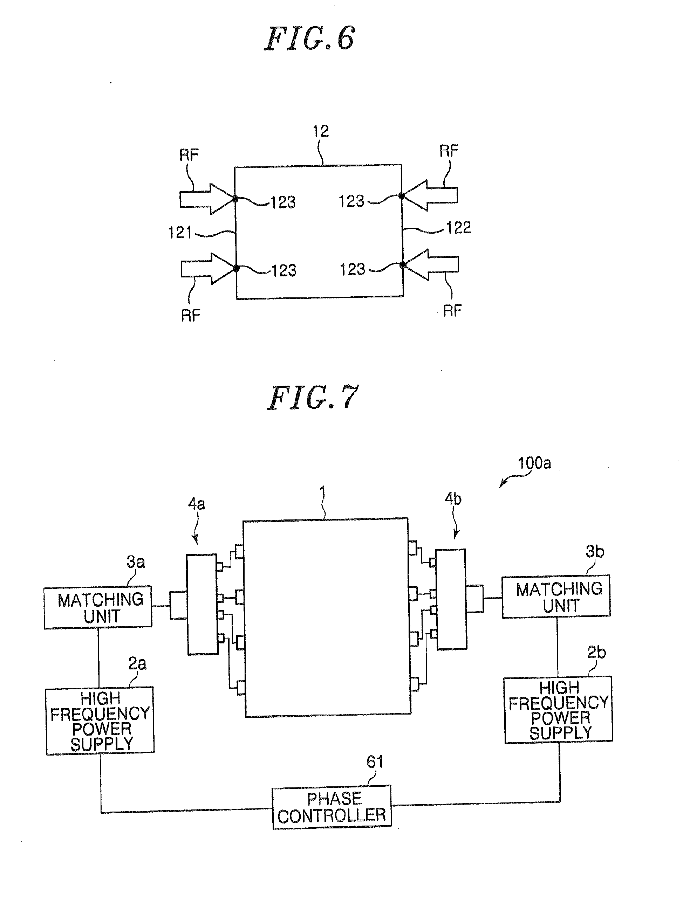

The high frequency power distributed to each of the upper electrodes 12 is supplied through two high frequency power feeding points thereof, so that a peak voltage of standing waves generated at the upper electrode 12 can be decreased and the in-plane distribution of the plasma processing can be more uniform. By increasing the number of high frequency power feeding points 123 up to, e.g., 4, as shown in Fig. 6, the peak voltage of the standing waves can be further decreased and the in-plane distribution of the plasma processing can be further improved. In Fig. 6, the numerals 121 and 122 represent two opposite ends (a first and a second ends) at which the high frequency power feeding points 123 are disposed.

Hereinafter, a substrate processing apparatus in accordance with another embodiment of the present invention will be described.

Fig. 7 is a schematic diagram showing a substrate processing apparatus in accordance with another embodiment of the present invention. In a substrate processing apparatus 100a of the present embodiment, a phase controller 61 is connected to high frequency power supply units 2a and 2b, so that a phase difference of the two high frequency power supply units 2a and 2b can be controlled. Accordingly, the stability of the plasma and the result of the plasma processing can be controlled. In that case, the phase difference can be set within the range of about 0° to 360° by the phase controller 61.

Next, a substrate processing apparatus in accordance with another embodiment of the present invention will be described.

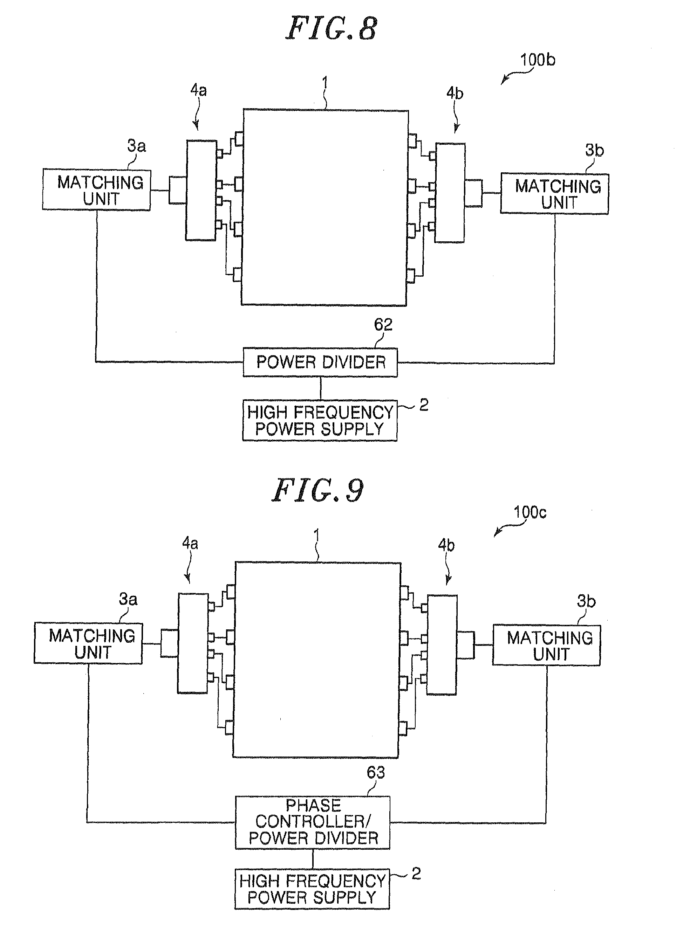

Fig. 8 is a schematic diagram showing a substrate processing apparatus in accordance with further another embodiment of the present invention. In a substrate processing apparatus 100b of the present embodiment, a power from a single high frequency power supply 2 is divided by a power divider (a power splitter) 62, and the divided powers are outputted to the matching units 3a and 3b, respectively.

In this case, the power divider 62 adjusts the impedance to, e.g., about 50 Ω, and distributes the high frequency powers that are controlled to have the same phase, to the matching units 3a and 3b at a proper power distribution ratio. If necessary, the power divider 62 can be controlled to have phases other than the same phase. Further, in the present embodiment, the stability of the plasma and the result of the plasma processing can be adjusted by controlling the power distribution ratio of the high frequency powers having the same phase. In the present embodiment, since a single high frequency power supply is used, cost effectiveness can be obtained.

Hereinafter, a substrate processing apparatus in accordance with still another embodiment of the present invention will be described.

Fig. 9 is a schematic diagram showing a substrate processing apparatus in accordance with another embodiment of the present invention. In a substrate processing apparatus 100c of the present invention, a high frequency power from a single high frequency power supply 2 is outputted to the matching units 3a and 3b via a phase controller/power divider 63.

The phase controller/power divider 63 can control the phase of the high frequency powers distributed to the matching units 3a and 3b and also can control the power distribution ratio. Therefore, the stability of the plasma and the result of the plasma processing can be more accurately controlled. Besides, cost effectiveness can be further improved by using a single high frequency power supply as in the example shown in Fig. 8.

The present invention can be variously modified without being limited to the above-described embodiments. For example, in the above-described embodiments, the substrate processing apparatus performs plasma CVD as the plasma processing. However, the present invention is not limited thereto, and may be applied to another plasma processing such as plasma etching or the like. Further, the number of substrates processed at one time can be changed without being limited to four. The division number of the high frequency power by the high frequency power distribution device can be determined in accordance with the number of substrates processed at one time.

In the above-described embodiments, the divided high frequency powers are applied to the parallel plate upper electrodes. However, the divided high frequency powers may be applied to the lower electrodes or to both of the upper and the lower electrodes. Although the above-described embodiments have described the example in which the high frequency power is supplied to two or four portions of the upper electrode, the high frequency power may be supplied to a single portion of the upper electrode. The substrate used in the present invention is not particularly limited, and various substrates such as a substrate for use in solar cell, a glass substrate for use in flat panel display (FPD) and the like can be used.

While the invention has been shown and described with respect to the embodiments, it will be understood by those skilled in the art that various changes and modification may be made without departing from the scope of the invention as defined in the following claims.

## Claims

1. A high frequency power distribution device for uniformly distributing a high frequency power from a high frequency power supply to a plurality of parallel plate electrodes in a substrate processing apparatus for processing a plurality of substrates in batches by generating a plasma by the high frequency power supplied to the parallel plate electrodes, the high frequency power distribution device comprising:
a distribution member for uniformly dividing a high frequency power inputted thereto into a plurality of divided high frequency powers;
coaxial transmission lines, each of which has a central power supply line and a ground line disposed around the central power supply line, to transmit the divided high frequency powers to the parallel plate electrodes; and
an impedance control mechanism which controls an input impedance to decrease a current value,
wherein the distribution member includes:
a main body made of a plate-shaped conductor;
a high frequency power input unit for inputting the high frequency power to an input point disposed on one surface of the main body; and
a plurality of high frequency power output units spaced from each other at a regular interval around a circle centering a point that is formed at the other surface of the main body so as to correspond to the input point,
wherein each of the coaxial transmission lines is connected to one of the high frequency power output units, and the impedance control mechanism is provided at the high frequency power input unit.

2. The high frequency power distribution device of claim 1, wherein the impedance control mechanism includes one or more capacitors connected in parallel to the high frequency power input unit.

3. The high frequency power distribution device of claim 1 or 2, wherein the coaxial transmission lines are connected to introduction terminals through which the divided high frequency powers are introduced to the parallel plate electrodes,
wherein the high frequency power distribution device further comprises impedance adjustment mechanisms provided at connecting portions of the coaxial transmission lines and the introduction terminals.

4. A substrate processing apparatus for performing a plasma processing on a plurality of substrates in batches, the apparatus comprising:
a plurality of parallel plate electrodes for generating a plasma for each of the substrates, the plate electrodes including high frequency power application electrodes;
a high frequency power supply for supplying a high frequency power to the high frequency power application electrodes;
an impedance matching unit provided between the high frequency power supply and the high frequency power application electrodes; and
a high frequency power distribution device, provided between the impedance matching unit and the high frequency power application electrodes, for uniformly distributing the high frequency power supplied from the high frequency power supply via the matching unit to the high frequency power application electrodes,
wherein the high frequency power distribution device includes:
a distribution member for uniformly dividing the high frequency power inputted thereto into a plurality of divided high frequency powers;
coaxial transmission lines each of which has a central power supply line and a ground line disposed around the central power supply line, to transmit the divided high frequency powers to the high frequency power application electrodes; and
an impedance control mechanism which controls an input impedance to decrease a current value,
wherein the distribution member includes:
a main body made of a plate-shaped conductor;
a high frequency power input unit for inputting the high frequency power to an input point disposed on one surface of the main body; and
a plurality of high frequency power output units spaced from each other at a regular interval around a circle centering a point that is formed on the other surface of the main body so as to correspond to the input point, and
wherein each of the coaxial transmission lines is connected to one of the high frequency power output units, and the impedance control mechanism is provided at the high frequency power input unit.

5. The substrate processing apparatus of claim 4, wherein the impedance control mechanism has one or more capacitor connected in parallel to the high frequency power input unit.

6. The substrate processing apparatus of claim 4 or 5, wherein the coaxial transmission lines are connected to introduction terminals through which the divided high frequency powers are introduced to the high frequency power application electrodes, and
wherein the high frequency power distribution device further comprises impedance adjustment mechanisms provided in the connecting portions of the coaxial transmission lines and the introduction terminals.

7. The substrate processing apparatus of any one of claims 4 to 6, wherein each of the high frequency power application electrodes has at least one pair of high frequency power feeding points disposed at a first and a second end thereof opposite to each other.

8. The substrate processing apparatus of claim 7, wherein the high frequency power supply includes a first high frequency power supply unit which supplies a high frequency power to a high frequency power feeding point disposed at the first end, and a second high frequency power supply unit which supplies a high frequency power to a high frequency power feeding point disposed at the second end.

9. The substrate processing apparatus of claim 8, further comprising a phase controller to which the first high frequency power supply and the second high frequency power supply are commonly connected.

10. The substrate processing apparatus of claim 7, wherein the high frequency power from the high frequency power supply is supplied via a power divider to the high frequency power feeding points disposed at the first and the second end.

11. The substrate processing apparatus of claim 7, wherein the high frequency power from the high frequency power supply is supplied via a phase controller/power divider to the high frequency power feeding points disposed at the first and the second end.
